# DEMANDE DE BREVET EUROPEEN

(11) **EP 1 291 922 A1**
(43) Date de publication de la demande: **12.03.2003**
(21) Numéro de dépôt: 02354133.7
(22) Date de dépôt: 04.09.2002
(51) Int. Cl.: H01L 29/08, H01L 21/762

(54) **Structure de contact sur une région profonde formée dans un substrat semiconducteur**

(30) Priorité: 06.09.2001 FR 0111556
(71) Demandeur: STMicroelectronics S.A., 92120 Montrouge (FR)
(72) Inventeur: Schwartzmann, Thierry, 38420 Le Versoud (FR)
(74) Mandataire: de Beaumont, Michel

(57) **Abrégé**

L'invention concerne la réalisation d'un contact avec une région profonde (42) d'un premier type de conductivité formée dans un substrat (10) en silicium comportant notamment un puits en silicium dopé (40) du premier type de conductivité et une région intermédiaire de connexion entre la couche profonde et le puits. Cette région intermédiaire de connexion est située au-dessous d'une tranchée (29). Le procédé de fabrication permet la réalisation de dispositifs verticaux, en particulier de transistors bipolaires rapides.

## Description

La présente invention concerne le domaine des circuits intégrés et plus particulièrement la réalisation d'une structure de contact avec une région profonde et dopée dans un substrat de silicium.

Certains composants électroniques constituant les circuits intégrés sont réalisés verticalement. C'est le cas, par exemple, des transistors bipolaires verticaux. L'émetteur et la base du transistor bipolaire vertical se situent en surface de la tranche en silicium. Le collecteur du transistor bipolaire est en profondeur dans le substrat. On doit alors réaliser la connexion entre le collecteur en profondeur et les interconnexions de surface du circuit intégré.

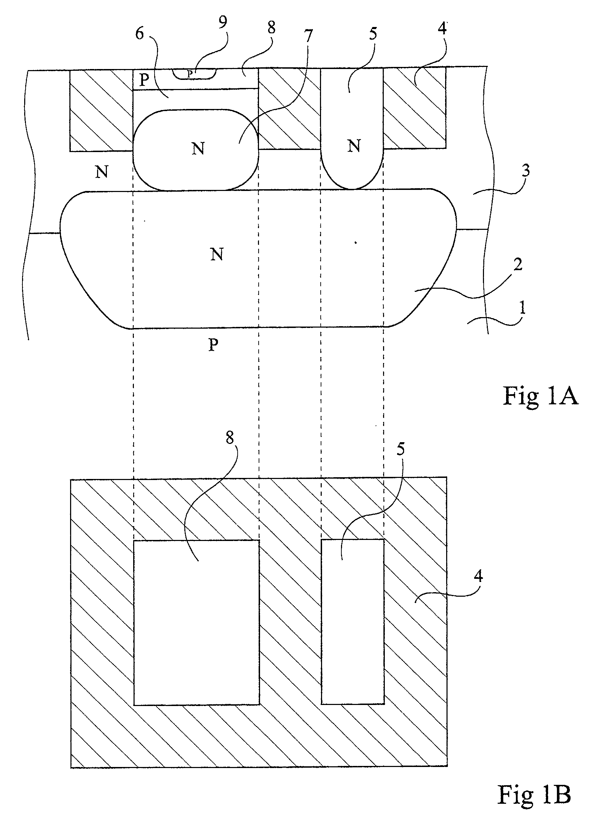

Un exemple de réalisation d'un transistor bipolaire NPN classique d'un circuit intégré est donné en figure 1A.

Dans un substrat 1 en silicium de type de conductivité P on implante localement des ions de façon à créer des régions 2 de type de conductivité N. On fait croître alors une couche épitaxiée 3 de type de conductivité N au-dessus de toute la surface du silicium. La région en silicium 2 devient alors une région enterrée. A titre d'exemple les ions dopant le substrat 1 sont des ions de bore avec une concentration de 1x10¹⁵ at/cm³. Les ions dopant la région 2 sont des ions d'arsenic avec une concentration de 5x10¹⁹ at/cm³. Les ions dopant la couche épitaxiée 3 sont des ions de phosphore avec une concentration de 5x10¹⁵ at/cm³.

Au-dessus de cette région enterrée 2, et à l'intérieur de la couche 3, on réalise un transistor bipolaire. Ce transistor bipolaire comporte un puits en silicium 5, un collecteur intrinsèque 6, une base 8 et un émetteur 9.

Le puits en silicium 5 est une région de silicium, du même type de conductivité N que la région 2, qui relie la région enterrée 2 à la surface de la tranche. Le collecteur intrinsèque 6 est une région de silicium du même type de conductivité que la région enterrée 2 et en contact électrique avec celle-ci grâce à une région de transition implantée 7 du même type de conductivité que les régions 6 et 2. La base 8 du transistor bipolaire est une région de silicium du type de conductivité P située à la surface du substrat. La base 8 est réalisée à l'intérieur de la couche épitaxiale 3 et se situe au-dessus du collecteur intrinsèque 6. L'émetteur 9 est une région de type de conductivité N, fortement dopée et strictement incluse dans la base 8. Afin d'isoler latéralement les divers éléments constitutifs du transistor bipolaire on utilise des tranchées 4 remplies d'oxyde. On entoure ainsi entièrement la base 8 par la tranchée 4 afin de l'isoler latéralement du puits en silicium 5.

La figure 1B, vue de dessus de la figure 1A, représente la tranchée 4 entourant entièrement la base 8 et le puits collecteur 5. Les autres régions de la figure 1A ne sont pas représentées, pour des raisons de clarté, sur cette figure 1B. Les prises de contacts sur l'émetteur, la base et le collecteur ne sont pas représentées sur la figure 1B. De même on n'a pas représenté un éventuel caisson P entourant le transistor bipolaire afin de l'isoler des autres éléments du circuit intégré.

Le fonctionnement d'un tel transistor est classique. Tant que le potentiel entre la base et l'émetteur n'est pas positif, les électrons situés dans l'émetteur 9 ne peuvent pas franchir la barrière de potentiel générée par la jonction base/émetteur. Dès que cette barrière de potentiel s'abaisse un flux d'électrons s'écoule de l'émetteur vers le collecteur intrinsèque. Le courant électrique ainsi généré est dirigé vers la surface du circuit intégré afin d'être traité par les autres éléments de ce circuit. Le courant collecteur parcourt successivement la région de transition 7, la couche enterrée 2 et le puits collecteur 5.

On cherche à optimiser le transistor bipolaire de façon à obtenir les performances les plus élevées possible. Pour cela l'homme du métier tente de diminuer l'épaisseur de la base 8 et de réduire toutes les capacités et les résistances internes du dispositif. Des contraintes dues au procédé technologique limitent la réduction de l'épaisseur de la base. C'est le cas, en particulier, lorsque les dopants de la région de transition 7 ou de la région enterrée 2 diffusent vers la surface dans la base 8. Le niveau de dopage de cette base est alors incontrôlable. On doit, pour éviter ce phénomène, diminuer les concentrations de dopants dans la région de transition 7 et dans la couche enterrée 2. On doit également augmenter la distance de ces sources de dopant à la base 8. Les résistances internes du dispositif augmentent alors fortement car les niveaux de dopage diminuent et les distances à parcourir par le courant augmentent. La capacité entre le collecteur et le substrat du transistor bipolaire doit également être optimisée afin d'améliorer les performances du transistor bipolaire. Cette capacité est proportionnelle à la surface de la jonction entre les régions 2 et le substrat 1. Il faut pour améliorer les performances du transistor bipolaire réduire la taille de la région 2 sans augmenter aucune résistance interne du dispositif.

Les différents niveaux de dopage et les dimensions internes du dispositif sont de plus en plus difficiles à optimiser au fur et à mesure que les règles de dessin qui gèrent les dimensions minimales utilisables pour le dispositif diminuent.

Un objet de la présente invention est de permettre la diminution des résistances internes d'un dispositif utilisant une région profonde dopée et la diminution de la capacité parasite de ladite région profonde, c'est-à-dire la réduction des dimensions de ladite région profonde.

Un autre objet de la présente invention est d'accroître les performances des transistors bipolaires verticaux.

Un autre objet de la présente invention est de diminuer sensiblement les coûts de fabrication des dispositifs nécessitant un contact vers une couche profonde de silicium dopé.

Pour atteindre ces objets, la présente invention prévoit une structure de contact avec une région profonde d'un premier type de conductivité formée dans un substrat semiconducteur, comportant une tranchée adjacente à la région profonde ; une région intermédiaire du premier type de conductivité située au-dessous de la tranchée et en contact électrique avec la région profonde ; et un puits en silicium dopé du premier type de conductivité en contact électrique avec la région intermédiaire et disjoint de la région profonde.

Selon un mode de réalisation de la présente invention, le premier type de conductivité est N ; le substrat est du silicium monocristallin dont le type de conductivité est P ; le dopage de la région profonde est supérieur à 5x10¹⁸ at/cm³ ; le dopage de la région intermédiaire est supérieur à 1x10¹⁹ at/cm³ ; et le dopage du puits en silicium dopé est supérieur à 1x10¹⁹ at/cm³.

Selon un mode de réalisation de la présente invention, la région intermédiaire recouvre partiellement la région profonde et le puits en silicium dopé.

Selon un mode de réalisation de la présente invention, la région profonde est bornée latéralement, au moins en sa partie supérieure, par une tranchée.

Selon un mode de réalisation de la présente invention, la région profonde, la région intermédiaire et le puits dopé constituent la prise de contact du collecteur d'un transistor bipolaire.

Selon un mode de réalisation de la présente invention, la région profonde constitue la base profonde d'un transistor bipolaire et la région intermédiaire et le puits dopé constituent la prise de contact sur la base profonde du transistor bipolaire.

Selon un mode de réalisation de la présente invention, la région profonde est disposée entre un caisson d'un second type de conductivité et le substrat d'un second type de conductivité afin d'isoler le caisson du substrat.

La présente invention prévoit aussi un procédé de réalisation d'un contact avec une région profonde d'un premier type de conductivité formée dans un substrat en silicium d'un second type de conductivité, comportant les étapes suivantes :
a) graver une tranchée dans le substrat ;
b) implanter au fond de la tranchée un dopant qui, après diffusion, formera une région intermédiaire du premier type de conductivité ;
c) remplir la tranchée avec au moins un matériau diélectrique ;
d) implanter un puits en silicium du premier type de conductivité adjacent à la tranchée ;
e) implanter avec un dopant du premier type de conductivité une région profonde adjacente à ladite tranchée et disjointe du puits en silicium dopé ; et
f) effectuer au moins un recuit de la structure après l'une au moins des opérations b) à e) de façon à former, par diffusion des dopants implantés sous la tranchée, une région intermédiaire du premier type de conductivité se confondant en partie avec la région profonde et le puits.

Selon un mode de réalisation de la présente invention, une tranchée remplie d'au moins un matériau diélectrique délimite l'implantation du dopant du premier type de conductivité dans la région profonde.

Selon un mode de réalisation de la présente invention, la région profonde et la tranchée remplie isolent le substrat initial du substrat d'un second type de conductivité d'un transistor MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A. et 1B représentent un transistor NPN réalisé selon l'art antérieur ;
les figures 2, 3A, 3B, 4 représentent des étapes successives de fabrication d'une structure de contact sur une région profonde formée dans un substrat semiconducteur selon la présente invention ;
les figures 5 et 6 représentent les profils de dopage selon deux coupes verticales ;
la figure 7 représente un transistor MOS latéral à caisson isolé selon la présente invention ;
la figure 8 représente un transistor bipolaire vertical optimisé avec la présente invention.

Dans les diverses figures, des éléments homologues sont désignés par les mêmes références. De plus, comme cela est habituel dans la représentation des circuits intégrés, les diverses figures ne sont pas tracées à l'échelle.

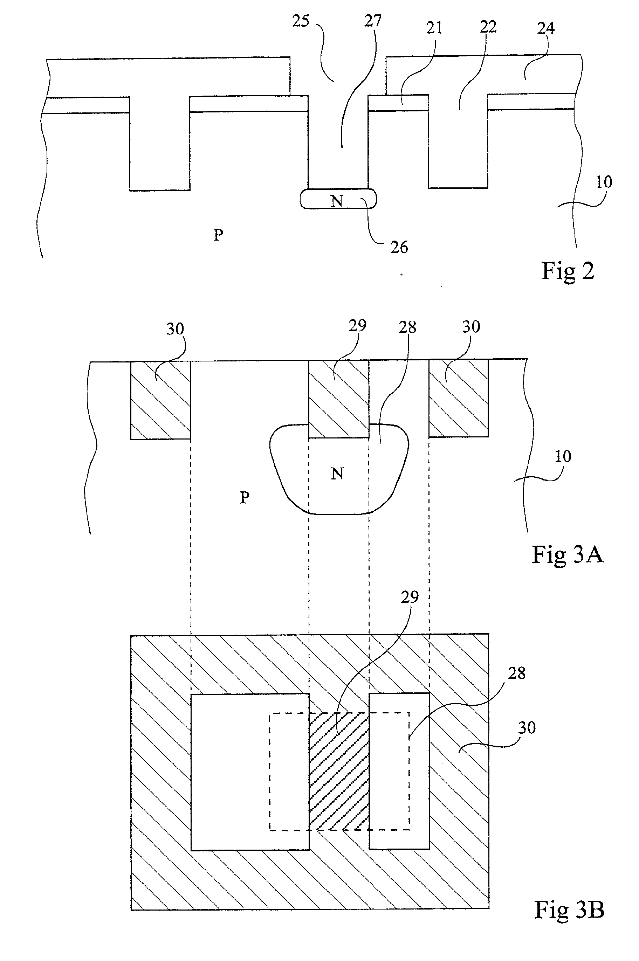

La figure 2 représente une étape initiale de la réalisation d'une structure de contact sur une région profonde selon la présente invention. On dépose sur un substrat en silicium 10 de type P, une couche de protection 21, par exemple du nitrure de silicium de 100 nm d'épaisseur. En utilisant une étape de photolithographie on grave la couche 21 et on crée, dans la partie supérieure du substrat en silicium 10 des tranchées, par exemple selon le motif illustré dans la vue de dessus de la figure 1B. Trois coupes de tranchée sont représentées. Un masque de résine 24 crée une ouverture 25 au droit de la tranchée centrale 27. On implante de l'arsenic à une dose inférieure à 5x10¹⁶ at/cm² et avec une énergie inférieure à 100 keV à travers cette ouverture. Les ions d'arsenic sont alors stoppés par la résine 24 ou la couche 21 de telle façon que seul le fond de la tranchée centrale 27 soit implanté dans une région en silicium 26.

Les figures 3A et 3B représentent une étape suivante de la réalisation de la structure de contact sur une région profonde selon la présente invention. La figure 3A représente une partie du substrat de silicium vu en coupe ; la figure 3B représente une partie du substrat de silicium vu de dessus. On élimine la résine 24, et on remplit, de manière classique, les tranchées avec un isolant. Une étape de polissage mécano-chimique et un recuit terminent le processus de création des tranchées isolantes. Au-dessous de la tranchée centrale une région intermédiaire en silicium 28 de type N est obtenue par diffusion des dopants, implantés dans la région 26, durant ledit recuit. Pour des raisons de clarté on désigne par la référence 29 les tranchées remplies situées au-dessus d'une région intermédiaire 28 et par la référence 30 les tranchées remplies non situées au-dessus d'une région intermédiaire 28. La figure 3B représente deux régions de silicium entièrement entourées d'une tranchée 29, 30.

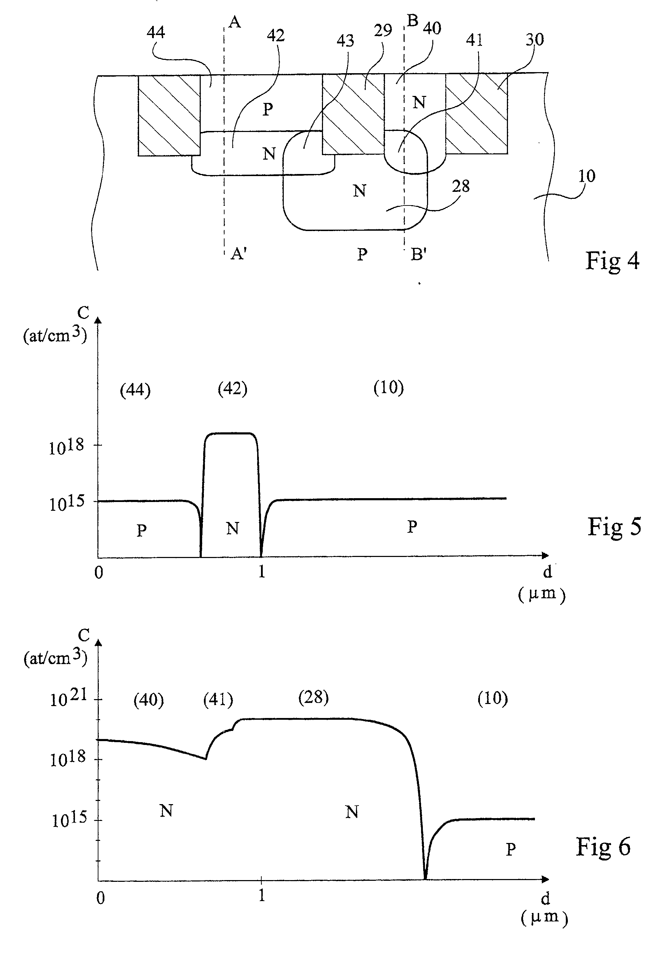

La figure 4 illustre une étape suivante du procédé de fabrication de la structure de contact sur une région profonde. On implante du phosphore à forte dose pour former un puits de silicium dopé 40 situé entre la tranchée centrale 29 et la tranchée de droite. Par exemple on implante du phosphore avec une dose comprise entre 2x10¹⁵ et 2x10¹⁶ at/cm² avec une énergie de 400 keV. Un recuit, par exemple de 950°C pendant vingt minutes, permet la diffusion de ce puits 40 de façon à ce qu'il recouvre partiellement la région intermédiaire 28 dans une région en silicium 41. Le puits en silicium 40 étant borné par des tranchées, ne s'étend pas latéralement même en cas de diffusion thermique importante des dopants. On implante ensuite du phosphore à forte énergie dans une région profonde en silicium 42 située entre la tranchée centrale 29 et la tranchée de gauche. Les tranchées masquent et bornent latéralement cette implantation. Par exemple on implante du phosphore avec une dose comprise entre 5x10¹⁴ et 2x10¹⁶ at/cm³ avec une énergie supérieure à 300 keV. Un recuit rapide, par exemple de 1000°C pendant 10 s, permet l'activation électrique du phosphore implanté sans provoquer de diffusion importante. La région profonde 42, de type N, recouvre une partie de la région intermédiaire 28 de type N, précédemment diffusée, dans une région en silicium 43. La région 42 délimite un caisson en silicium 44 de type P dont les frontières sont la région profonde 42, les tranchées et la surface du substrat. Une implantation ionique optionnelle effectuée dans ce caisson permet d'ajuster le type et le niveau de dopage du caisson 44. Si aucune implantation n'est effectuée, le caisson 44 possède le type et le niveau de dopage du substrat initial. Il est alors, dans le cas du présent exemple, entièrement isolé du substrat 10 de type P également. En effet le caisson 44 est isolé verticalement par des jonctions et latéralement par les tranchées.

Ainsi on vient de créer une structure de contact avec une région profonde 42 de type N constituée d'une région intermédiaire 28 et d'un puits en silicium dopé 40. On assure un contact électrique de faible résistance entre les différentes régions de cette structure par le recouvrement des régions 28 et 40 dans la zone 41 et des régions 28 et 42 dans la zone 43.

Les fonctionnalités des régions 42, 28, 40 de la figure 4 sont similaires respectivement à celles des régions 7, 2, 5 de la figure 1A. La région profonde 42 est comme la région 7, une région de transition pour le courant. Elle a en plus un rôle d'isolation verticale qui nécessite une augmentation de son dopage. La région intermédiaire 28 a un rôle similaire à celui de la couche enterrée 2 : elle conduit le courant de la région profonde 42 vers le puits de silicium dopé 40. Cependant les dimensions de cette région intermédiaire sont très réduites par rapport à celles de la couche enterrée 2. Les capacités parasites et les résistances associées à cette couche seront également très réduites.

La structure de la figure 4 autorise de meilleurs compromis pour l'intégration des dispositifs nécessitant une couche enterrée. Elle n'est pas limitée lorsque les dimensions des dispositifs diminuent. Elle est d'autant plus efficace que les dimensions sont petites, inférieures à 0.5 µm et de préférence inférieures à 0.1 µm.

Le procédé est économique car aucune étape d'épitaxie, coûteuse en milieu industriel, n'a été utilisée.

Les profils de dopage obtenus par ce procédé sont reproductibles car ils sont obtenus à partir d'implantations ioniques et de recuits thermiques limités. Le rendement de fabrication des circuits intégrés est amélioré.

La figure 5 représente le profil de dopage selon l'axe vertical AA' de la figure 4. Cet axe AA' traverse le caisson 44 et la couche profonde 42 perpendiculairement à la surface du silicium. L'axe des abscisses représente la profondeur (d) à partir de la surface du substrat 10, l'axe des ordonnées représente la concentration (c) d'atomes dopants suivant une échelle logarithmique. Ce profil de dopage démontre l'isolation par jonctions, dans le sens vertical, du caisson en silicium 44 de type P vis à vis du substrat 10 de type P. Pour obtenir cette isolation il faut polariser en inverse les deux jonctions N/P créées entre les régions 42 et 44 d'une part et entre la région 42 et le substrat 10 d'autre part. Une tension positive doit être appliquée à la région profonde 42, en utilisant la région intermédiaire 28 et le puits 40.

La figure 6 représente la concentration c en fonction de la profondeur d selon l'axe vertical BB' de la figure 4. Cet axe BB' traverse le puits en silicium dopé 40, la région 41 et la région 28. Ce profil de dopage démontre la continuité électrique entre les régions 40 et 28 et en particulier la superposition des concentrations des atomes dopants des régions 40 et 28 dans la région 41. Cette sur-concentration de la région 41 associée à la faible profondeur du puits dopé 40 permet d'obtenir une résistance minimale pour le flux de courant traversant successivement les régions 40 et 28 dans le sens de l'axe BB'.

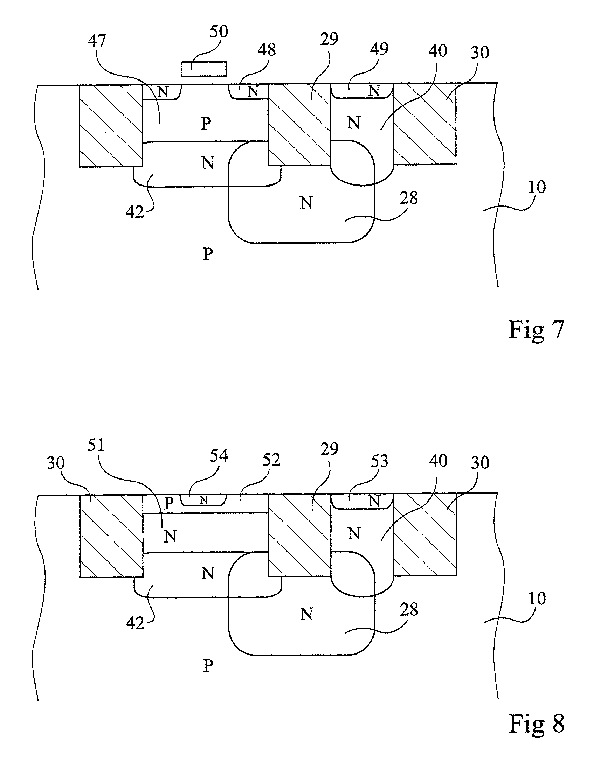

La figure 7 représente la structure d'un transistor MOS latéral selon la présente invention dont le caisson est entièrement isolé. A partir des opérations technologiques réalisées à la figure 4, une implantation ionique de bore est effectuée dans le caisson en silicium 44 désigné maintenant par la référence 47. Cette implantation permet l'ajustement du niveau de dopage du substrat en silicium 47 du futur transistor MOS. De manière classique on fait croître un oxyde de grille, on dépose et on grave du silicium polycristallin 50 qui forme la grille du transistor MOS. On implante avec une forte dose d'arsenic les régions 48 de source et drain du transistor MOS ainsi que la surface 49 du puits en silicium dopé 40. Le substrat 47 de ce transistor MOS est entièrement isolé du substrat initial 10 tant qu'une différence de potentiel positive existe entre la région profonde 42 et les régions en silicium adjacentes de dopage opposé. Cette configuration connue sous le nom de triple caisson à été obtenue sans traitement thermique important - ce qui est incompatible avec les procédés de fabrication submicronique - et sans croissance d'une couche de silicium épitaxiée. Le niveau de dopage de la région 42 permet d'ajuster la tenue en tension du substrat 47 du transistor MOS vis à vis du substrat initial 10 et de réduire le gain du transistor bipolaire parasite formé par le substrat 47 du transistor MOS, la région profonde 42, et le substrat initial 10. Le thyristor parasite généré par les sources et les drains 48 du transistor MOS, le caisson isolé 47, la région profonde 42 et le substrat 10 est également un paramètre important pour l'optimisation de cette structure. En particulier ce thyristor parasite ne peut pas se déclencher si le potentiel de la région profonde 42 est bien contrôlé. Pour cela il faut que la résistance d'accès à la région profonde 42 à travers la région intermédiaire 28 et le puits en silicium dopé 40 soit faible. La présente invention permet un contrôle aisé de tous les paramètres physiques des régions 49, 40, 28, 42, 47 afin d'optimiser cette structure à triple caisson. La compacité de la structure obtenue permet une intégration facile dans les circuits numériques à haute densité d'intégration utilisant des transistors MOS. Cette compacité permet également de diminuer toutes les résistances internes parasites et d'éviter ainsi le déclenchement intempestif des thyristors parasites.

La figure 8 représente la structure d'un transistor bipolaire selon la présente invention. A partir des opérations technologiques réalisées à la figure 4, on réalise une implantation de phosphore dans la région 44. Cette implantation compense le niveau de dopage initial de type P de cette région et permet d'obtenir localement une région 51 dont le dopage est de type N. Par des opérations courantes en technologie bipolaire on réalise alors la base 52 du transistor bipolaire, la prise de contact 53 du collecteur et la région 54 d'émetteur. La présente invention permet d'obtenir une faible résistance entre le collecteur intrinsèque 51 du transistor bipolaire et la prise collecteur 53. La surface entre d'une part les zones 42, 28, 40 et d'autre part le substrat 10 est minimisée et circonscrite à l'intérieur du périmètre défini par les tranchées entourant le transistor bipolaire. La capacité du collecteur du transistor bipolaire est faible. Les deux caractéristiques ci-dessus permettent d'accroître sensiblement les performances dynamiques du composant, en particulier la fréquence maximale de fonctionnement (Furax) ainsi que la fréquence de transition (Ft).

Bien entendu, la présente invention est susceptible de diverses variantes et modifications qui apparaîtront à l'homme de l'art. En particulier, on peut changer, selon les objectifs, le type de dopant des différentes couches ainsi que les ions implantés pour créer les zones dopées.

On peut utiliser n'importe quel type de substrat de départ tant qu'il existe à sa surface une couche faiblement dopée. En particulier les substrats épitaxiés utilisés en technologie MOS sont adaptés à la présente invention. Ces substrats en silicium, très fortement dopés en volume, présentent sur leur face avant une couche de silicium épitaxié de 10 à 20 µm d'épaisseur et faiblement dopé.

On peut utiliser le mode d'accès à des couches profondes selon la présente invention pour réaliser des accès à des couches profondes de divers types constituant des éléments de divers composants.

On peut par exemple réaliser des dispositifs de type bipolaire avec une base 42 profonde et avec une reprise du contact de base en surface. On peut agencer ces transistors bipolaires pour faire des structures thyristor.

Tout dispositif fonctionnant verticalement, le courant devant être collecté en volume, peut avantageusement être réalisé à partir de la présente invention.

## Revendications

1. Structure de contact avec une région profonde (42) d'un premier type de conductivité formée dans un substrat semiconducteur, **caractérisée en ce qu'**elle comporte :
une tranchée (29) adjacente à la région profonde (42) ;
une région intermédiaire (28) du premier type de conductivité située sous la tranchée (29), sensiblement en alignement avec celle-ci, et en contact électrique avec la région profonde (42) ;
un puits en silicium dopé (40) du premier type de conductivité en contact électrique avec la région intermédiaire (28) et disjoint de la région profonde (42).

2. Structure de contact selon la revendication 1, **caractérisée en ce que** :
le premier type de conductivité est N ;
le substrat est du silicium monocristallin dont le type de conductivité est P ;
le dopage de la région profonde (42) est supérieur à 5x10¹⁸ at/cm³ ;
le dopage de la région intermédiaire (28) est supérieur à 1x10¹⁹ at/cm³ ;
le dopage du puits en silicium dopé (40) est supérieur à 1x10¹⁹ at/cm³.

3. Structure de contact selon la revendication 1, **caractérisée en ce que** la région intermédiaire (28) recouvre partiellement la région profonde (42) et le puits en silicium dopé (40).

4. Structure de contact selon la revendication 1, **caractérisée en ce que** la région profonde (42) est bornée latéralement, au moins en sa partie supérieure, par une tranchée (29, 30).

5. Structure de contact selon la revendication 1, **caractérisée en ce que** la région profonde (42), la région intermédiaire (28) et le puits dopé (40) constituent la prise de contact du collecteur d'un transistor bipolaire.

6. Structure de contact selon la revendication 1, **caractérisée en ce que** la région profonde (42) constitue la base profonde d'un transistor bipolaire et **en ce que** la région intermédiaire (28) et le puits dopé (40) constituent la prise de contact sur la base profonde du transistor bipolaire.

7. Structure de contact selon la revendication 1, **caractérisée en ce que** la région profonde (42) est disposée entre un caisson (44, 47) d'un second type de conductivité et le substrat (10) d'un second type de conductivité afin d'isoler le caisson (44, 47) du substrat (10).

8. Procédé de réalisation d'un contact avec une région profonde (42) d'un premier type de conductivité formée dans un substrat (10) en silicium d'un second type de conductivité, **caractérisé en ce qu'**il comporte les étapes suivantes :
a) graver une tranchée dans le substrat (10) ;
b) implanter au fond de la tranchée un dopant qui, après diffusion, formera une région intermédiaire (28) du premier type de conductivité ;
c) remplir la tranchée (29) avec au moins un matériau diélectrique ;
d) implanter un puits en silicium du premier type de conductivité (40) adjacent à la tranchée (29) ;
e) implanter avec un dopant du premier type de conductivité une région profonde (42) adjacente à ladite tranchée (29) et disjointe du puits en silicium dopé (40) ; et
f) effectuer au moins un recuit de la structure après l'une au moins des opérations b) à e) de façon à former, par diffusion des dopants implantés sous la tranchée (27, 29), une région intermédiaire (28) du premier type de conductivité se confondant en partie avec la région profonde (42) et le puits (40).

9. Procédé selon la revendication 8, **caractérisé en ce qu'**une tranchée remplie d'au moins un matériau diélectrique (29, 30) délimite l'implantation du dopant du premier type de conductivité dans la région profonde (42).
